# EUROPEAN PATENT APPLICATION

(11) **EP 2 224 489 A1**
(43) Date of publication of application: **01.09.2010**
(21) Application number: 08864813.4
(22) Date of filing: 11.11.2008
(51) Int. Cl.: H01L 29/739, H01L 29/12, H01L 29/78

(54) **SEMICONDUCTOR DEVICE**

(30) Priority: 21.12.2007 JP 2007330404
(71) Applicant: Toyota Jidosha Kabushiki Kaisha, Toyota-shi, Aichi 471-8571 (JP)
(72) Inventor: NISHIDA, Shuichi, Toyota-shi Aichi 471-8571 (JP); OHNISHI, Toyokazu, Toyota-shi Aichi 471-8571 (JP); SHOJI, Tomoyuki, Aichi-gun Aichi 480-1192 (JP)
(74) Representative: Intes, Didier Gérard André
(86) International application number: PCT/JP2008/070474
(87) International publication number: WO 2009/081667

(57) **Abstract**

A technique is presented for further reducing on-resistance (or on-voltage) in a vertical semiconductor device provided with a carrier shielding layer.

A semiconductor substrate 20 of a semiconductor device 10 comprises a channel section 10A and a non-channel section 10B. An emitter region 26 is formed in the channel section 10A, this emitter region 26 making contact with a side surface of a trench gate 30 and being electrically connected to an emitter electrode 28. The emitter region 26 is not formed in a body region 25 of the non-channel section 10B. In a plan view, an occupied area ratio of the area which a carrier shielding layer 52 located in the non-channel section 10B occupies within the non-channel section 10B is larger than an occupied area ratio of the area which the carrier shielding layer 52 located in the channel section 10A occupies within the channel section 10A.

## Description

### [Field of the Invention]

The present application claims priority to Japanese Patent Application Publication No. 2007-330404 filed on December 21, 2007, the contents of which are hereby incorporated by reference into the present specification.
The present invention relates to a vertical semiconductor device.

### [Background of the Invention]

A vertical semiconductor device comprises a pair of main electrodes disposed respectively on a surface and a rear surface of a semiconductor substrate. The vertical semiconductor device is often provided with a trench gate in order to reduce on-resistance (or on-voltage). In order to further reduce the on-resistance (or on-voltage), techniques that utilize a carrier shielding layer in vertical semiconductor devices provided with a trench gate are being developed. Japanese Patent Application Number 2007-266622 teaches a vertical semiconductor device provided with a carrier shielding layer (a charge shielding layer).

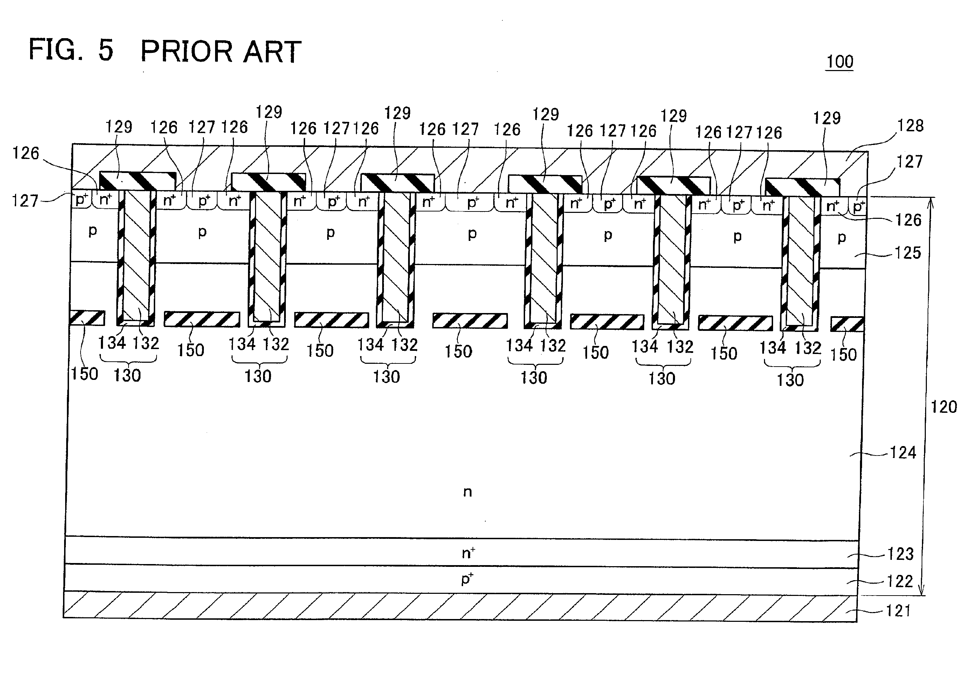

FIG. 5 schematically shows a vertical cross-sectional view of essential parts of the semiconductor device 100 taught in Japanese Patent Application Number 2007-266622. In the semiconductor device 100, an emitter electrode 128 is disposed on a surface of a semiconductor substrate 120, and a collector electrode 121 is disposed on a rear surface of the semiconductor substrate 120. The semiconductor substrate 120 is provided with stacked layers having, a p⁺ type collector region 122, an n⁺ type buffer region 123, an n type drift region 124, and a p type body region 125 in sequence from the rear surface.

The semiconductor device 100 comprises a plurality of trench gates 130 that penetrates a body region 125. Each trench gate 130 is provided with a gate insulating layer 134 and a trench gate electrode 132 that is covered by the gate insulating layer 134. The trench gate electrode 132 and the emitter electrode 128 are electrically insulated by an interlayer insulating layer 129.

The semiconductor device 100 further comprises a plurality of p⁺ type body contact regions 127 and n⁺ type emitter regions 126 disposed selectively on a surface layer portion of the semiconductor substrate 120. The emitter regions 126 are in contact with a side surface of the trench gate 130. The body contact region 127 and the emitter region 126 are electrically connected to the emitter electrode 128.

The semiconductor device 100 further comprises a carrier shielding layer 150 disposed within a drift region 124. The carrier shielding layer 150 is made from, for example, silicon oxide. The carrier shielding layer 150 is disposed between the trench gates 130.

The carrier shielding layer 150 is capable of preventing the movement of positive holes injected into the drift region 124 from the collector region 122 at the rear surface. The concentration of positive holes within the drift region 124 is thereby increased, and the on-resistance (or on-voltage) is reduced.

### [Disclosure of the Invention]

### [Problem to be Solved by the Invention]

It is desirable to further reduce the on-resistance (or on-voltage) in the technique that utilizes a carrier shielding layer. The present invention aims to present a technique for further reducing the on-resistance (or on-voltage) in a vertical semiconductor device provided with a carrier shielding layer.

### [Means to Solve the Problem]

The vertical semiconductor device taught in the present specification comprises a semiconductor substrate, a plurality of trench gates, and a carrier shielding layer. The semiconductor substrate comprises a first semiconductor region of a first conductive type, a second semiconductor region of a second conductive type disposed above the first semiconductor region, and a surface semiconductor region of the first conductive type selectively disposed above the second semiconductor region and electrically connected to a surface electrode. The plurality of trench gate electrodes penetrates the second semiconductor region. The carrier shielding layer is disposed in the first semiconductor region. In the vertical semiconductor device taught in the present specification, the semiconductor substrate has a channel section and a non-channel section. The channel section is a section located between the trench gates, and the surface semiconductor region is disposed in the channel section such that the surface semiconductor region is in contact with a side surface of at least one of the trench gates. That is, the second semiconductor region is disposed along the side surface of at least one of the trench gates between the surface semiconductor region and the first semiconductor region, and a channel is formed in the second semiconductor region by applying voltage to the trench gate. The non-channel section is a section located between the trench gates, and the surface semiconductor region is not disposed in the non-channel section. As a result, channels are not formed in the non-channel section. In the vertical semiconductor device taught in the present specification, in a plan view, an occupied area ratio of the area which the carrier shielding layer located in the non-channel section occupies within the non-channel section is larger than an occupied area ratio of the area which the carrier shielding layer located in the channel section occupies within the channel section. Here, if the area of the channel section (or the non-channel section), viewed in the plan view is assumed as being "1", the "occupied area ratio" refers to the proportion of area that the carrier shielding layer occupies within the channel section (or the non-channel section). The "occupied area ratio" includes "0", which being the case where the carrier shielding layer is completely absent from the channel section, and "1", which being the case where the carrier shielding layer is present across the entirety of the non-channel section. The larger the occupied area ratio of the carrier shielding layer, the more prohibited is the movement of the carriers in the vertical direction within that section.
According to this semiconductor device, a portion of a first type of carriers, these being injected into the first semiconductor region of the non-channel section from the rear surface side, is prevented by the carrier shielding layer from moving in the vertical direction, and moves in a horizontal direction. Since the carrier shielding layer has a small occupied area ratio in the channel section, the first type of carriers that have moved in the horizontal direction accumulate in the channel section. By contrast, a second type of carriers is injected from the surface semiconductor region of the channel section. Since the first type of carriers and the second type of carriers consequently accumulate in the channel section, conductivity modulation is activated, and the on-resistance (or on-voltage) of the semiconductor device is markedly reduced.
Compared to increasing the carrier concentration in the semiconductor substrate uniformly by means of the carrier shielding layer, dividing the semiconductor substrate into the channel section and the non-channel section, as in the case of the semiconductor device shown in FIG. 5, markedly reduces the on-resistance (or on-voltage) when the carriers are accumulated in the channel section. When the carriers are accumulated in the channel section, the reduction in the channel area caused by forming the non-channel section is compensated for, and the on-resistance (or on-voltage) can be reduced. The semiconductor device taught in the present specification utilizes this phenomenon, and differs clearly in its operation and effects from the semiconductor device shown in FIG. 5. The semiconductor device taught in the present specification comprises an innovative and novel technical concept.

### [Effects of the Invention]

According to the technique taught in the present specification, it is possible to accumulate the carriers in the channel section and activate the conductivity modulation. The reduction in the channel area caused by forming the non-channel section is compensated for by accumulating the carriers in the channel section, and the on-resistance (or on-voltage) can be reduced.

### [Brief Description of the Drawings]

FIG. 1 shows a cross-sectional view schematically showing essential parts of a semiconductor device 10 of the present embodiment.
FIG. 2 shows a cross-sectional view schematically showing essential parts of a semiconductor device 11 of the present embodiment.
FIG. 3 shows a cross-sectional view schematically showing essential parts of a semiconductor device 12 of the present embodiment.
FIG. 4 shows a cross-sectional view schematically showing essential parts of a semiconductor device 13 of the present embodiment.
FIG. 5 shows a cross-sectional view schematically showing essential parts of a conventional semiconductor device 100.

### [Preferred Features for Realizing the Invention]

A vertical semiconductor device taught in the present specification comprises a semiconductor substrate, a plurality of trench gates, and a carrier shielding layer. The semiconductor substrate comprises a first semiconductor region of a first conductive type, a second semiconductor region of a second conductive type disposed above the first semiconductor region, and a surface semiconductor region of the first conductive type selectively disposed above the second semiconductor region and electrically connected to a surface electrode. The plurality of trench gate electrodes penetrates the second semiconductor region. The carrier shielding layer is disposed in the first semiconductor region. In the vertical semiconductor device taught in the present specification, the semiconductor substrate has a channel section and a non-channel section. The channel section is a section located between the trench gates, and the surface semiconductor region is disposed in the channel section such that the surface semiconductor region is in contact with a side surface of at least one of the trench gates. The non-channel section is a section located between the trench gates, and the surface semiconductor region is not disposed in the non-channel section. In the vertical semiconductor device taught in the present specification, in a plan view, an occupied area ratio of the area which the carrier shielding layer located in the non-channel section occupies within the non-channel section is larger than an occupied area ratio of the area which the carrier shielding layer located in the channel section occupies within the channel section.

In the vertical semiconductor device, it is preferred that the carrier shielding layer is located in the non-channel section, and opens into at least a portion of the channel section. According to this feature, the first type of carriers, whose movement in the vertical direction were prevented in the non-channel section, are moved in the horizontal direction, and can be accumulated in the opening of the channel section.

In the vertical semiconductor device, it is preferred that the carrier shielding layer is disposed at a depth which is deeper than the trench gate.
Even if the positional relationship of the carrier shielding layer and the trench gate shifts slightly due to the shifting caused in the positioning of a mask, disposing the carrier shielding layer at a depth which is deeper than the trench gate can cause this change in the positional relationship to have only a minor effect on the properties of the semiconductor device.

In the vertical semiconductor device, it is preferred that the carrier shielding layer spreads from an area below one of the trench gates to an area below another trench gate in the non-channel section.
According to this feature, the majority of the first type of carriers having been injected from the rear surface into the first semiconductor region of the non-channel section is moved in the horizontal direction by the carrier shielding layer, and thus can be accumulated in the channel section. Conductivity modulation in the channel section is further activated, and the on-resistance (or on-voltage) can be further reduced.

In the vertical semiconductor device, a dummy trench gate penetrating the second semiconductor region may be disposed in the non-channel section. In this case, it is preferred that the carrier shielding layer is disposed at a depth which is deeper than the dummy trench gate.

In the vertical semiconductor device, it is preferred that the carrier shielding layer is disposed at a depth which is equal to or shallower than a diffusion length of the carriers from the surface of the semiconductor substrate.
The carriers that have accumulated in the channel section can thereby maintain their state of being converged even after having passed the opening of the carrier shielding layer and having reached the surface of the semiconductor substrate.

In the vertical semiconductor device described above, the material of the carrier shielding layer may be any material that inhibits the movement of the carriers to a greater extent than the semiconductor material that is surrounding the carrier shielding layer. For example, the carrier shielding layer can utilize silicon oxide, porous silicon, or silicon nitride. Further, the carrier shielding layer may be a cavity.

In the vertical semiconductor device described above, it is preferred that the carrier shielding layer opens into at least a portion of the channel section, and that in a plan view this opening is disposed so as to include an area below the surface semiconductor region. It is more preferred that the opening extends in the channel section from an area below one of the trench gates to an area below another trench gate.

In the vertical semiconductor device, it is preferred that a surface of a body region (an example of the second semiconductor region) of the non-channel section is covered by an insulating layer, and that the body region of the non-channel section is in a floating state.

### [Embodiments]

Embodiments will be described below with reference to figures. In the embodiments below, single-crystal silicon is used in the semiconductor material. However, another semiconductor material can be used alternatively. For example, a compound semiconductor may be utilized having gallium nitride, silicon carbide, and gallium arsenide in its semiconductor material. Further, although a punch through type IGBT (Insulated Gate Bipolar Transistor) will be described in the embodiments below, the technique taught in the present specification may also be applied to a non-punch through type IGBT. Further, the technique taught in the present specification may also be applied to a MOSFET (Metal Oxide Semiconductor Field Effect Transistor).

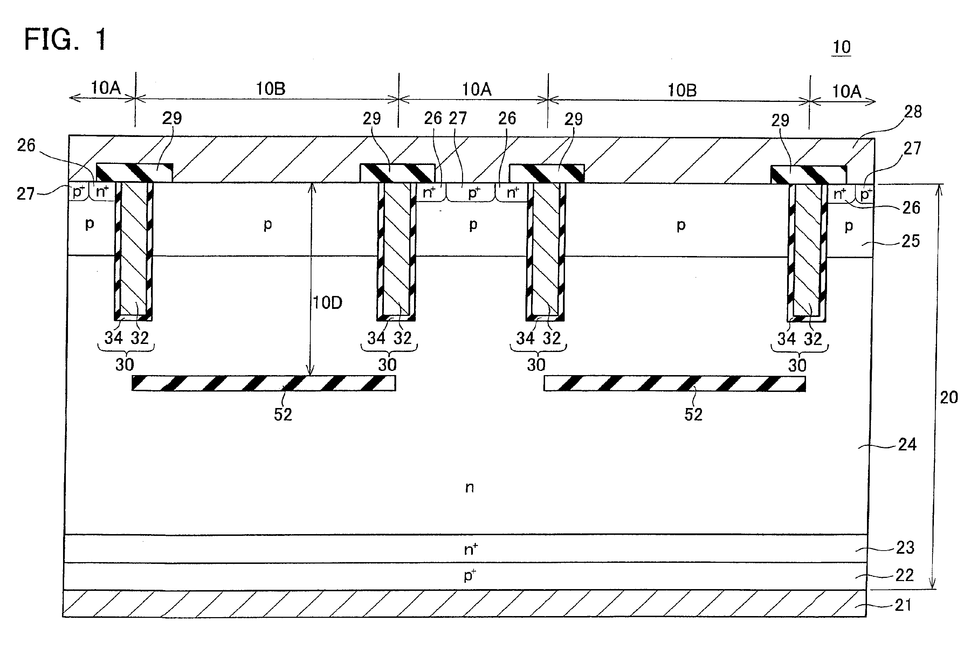

FIG. 1 schematically shows a vertical cross-sectional view of the essential parts of a semiconductor device 10. An emitter electrode 28 is formed in the semiconductor device 10 on a surface of a semiconductor substrate 20, and a collector electrode 21 is formed on a rear surface of the semiconductor substrate 20. Aluminum is utilized in the material of the emitter electrode 28, and aluminum, titanium, nickel, and gold are utilized in the material of the collector electrode 21. The emitter electrode 28 is fixed to ground potential, and positive voltage is applied to the collector electrode 21.

The semiconductor substrate 20 consists of stacked layers comprising, in sequence from the rear surface, a p⁺ type collector region 22, an n⁺ type buffer region 23, an n type drift region 24 (an example of the first semiconductor region) and a p type body region 25 (an example of the second semiconductor region). The collector region 22 and the buffer region 23 are formed on a rear layer portion of the semiconductor substrate 20 utilizing the ion injection technique. The body region 25 is also formed on a rear layer portion of the semiconductor substrate 20 utilizing the ion injection technique. The collector electrode 21 is electrically connected to the collector region 22.

The semiconductor device 10 comprises a plurality of trench gates 30 that penetrate the body region 25. Each trench gate 30 has a gate insulating layer 34 and a trench gate electrode 32 covered by the gate insulating layer 34. The material of the gate insulating layer 34 is silicon oxide, and the material of the trench gate electrode 32 is polysilicone into which a high concentration of impurities has been introduced. The trench gate electrode 32 and the emitter electrode 28 are electrically insulated by an interlayer insulating layer 29. The material of the interlayer insulating layer 29 is silicon oxide.

As shown in FIG. 1, the semiconductor substrate 20 of the semiconductor device 10 has a channel section 10A and a non-channel section 10B. The channel section 10A and the non-channel section 10B are disposed repeatedly along one direction along the plane of the semiconductor substrate 20. In this example, a plurality of channel sections 10A and a plurality of non-channel sections 10B are disposed reciprocally in a striped shape from a plan view. The channel section 10A is a section located between the trench gates 30, and an n⁺ type emitter region 26 (an example of the surface semiconductor region) and a p⁺ type body contact region 27 are selectively disposed above the body region 25 of the channel section 10A. The emitter region 26 and the body contact region 27 are electrically connected to the emitter electrode 28. By contrast, the non-channel section 10B is also a section located between the trench gates 30, but the emitter region 26 and the body contact region 27 are not disposed above the body region 25 of the non-channel section 10B. Moreover, in this example, the body contact region 27 is not disposed in the non-channel section 10B. However, as an alternative of this example, the body contact region 27 may also be disposed in the non-channel section 10B. The channel section 10A and the non-channel section 10B are differentiated by respectively having and being without the emitter region 26. The emitter region 26 of the channel section 10A is disposed so as to be in contact with a side surface of the trench gate 30.

The semiconductor device 10 further comprises a carrier shielding layer 52 disposed in the drift region 24. The carrier shielding layer 52 is located in the non-channel section 10B, and opens into the channel section 10A. The carrier shielding layer 52 is disposed at a depth which is deeper than the trench gate 30. Further, as shown in FIG. 1, a distance (depth) 10D from a surface of the semiconductor substrate 20 to the carrier shielding layer 52 is less than or equal to the diffusion length of the positive holes. That is, the distance 10D from the surface of the semiconductor substrate 20 to the carrier shielding layer 52 is configured to be longer than the trench gate 30, and is shorter than the diffusion length of the positive holes.

The carrier shielding layer 52 spreads laterally from below one of the trench gates 30 to below another trench gate 30 in the non-channel section 10B. That is, in the non-channel section 10B of the semiconductor device 10, in a plan view, the carrier shielding layer 52 is present across the entirety of the non-channel section 10B. By contrast, the opening of the carrier shielding layer 52 is formed within the channel section 10A from below one of the trench gates 30 to below the other trench gate 30. That is, in the channel section 10A of the semiconductor device 10, in a plan view, the carrier shielding layer 52 is not present in the channel section 10A. The material of the carrier shielding layer 52 is silicon oxide. Instead of silicon oxide, the material may be porous silicon, or may be a cavity.

In the non-channel section 10B of the semiconductor device 10, in a plan view, the carrier shielding layer 52 is present across the entirety of the non-channel section 10B. As a result, the occupied area ratio that the carrier shielding layer 52 disposed in the non-channel section 10B occupies in the non-channel section 10B is 1. By contrast, in the channel section 10A of the semiconductor device 10, in a plan view, the carrier shielding layer 52 is not present in the channel section 10A. As a result, the occupied area ratio of the carrier shielding layer 52 in the channel section 10A is 0. The occupied area ratio of the carrier shielding layer 52 has a relationship such that the occupied area ratio of the carrier shielding layer 52 in the non-channel section 10B is larger than the occupied area ratio of the carrier shielding layer 52 in the channel section 10A. In the semiconductor device 10, if the occupied area ratio of the carrier shielding layer 52 maintains the above relationship, the effect of decreasing the on-resistance (or on-voltage) can be achieved (this will be described later in detail). As a result, in the alternative examples of the semiconductor device 10, in a plan view, the carrier shielding layer 52 may be present in a portion of the channel section 10A, or the carrier shielding layer 52 may be absent in a portion of the non-channel section 10B, as long as the occupied area ratio of the carrier shielding layer 52 maintains the above relationship of being larger in the non-channel section 10B and smaller in the channel section 10A.

Next, the operation of the semiconductor device 10 will be described.
In the semiconductor device 10, the trench gate electrode 32 is switched on and off by applying or not applying a positive voltage that is equal to or greater than a threshold voltage. When the voltage equal to or greater than the threshold voltage is not being applied to the trench gate electrode 32, electrons cannot be injected from the emitter region 26 to the drift region 24 via the body region 25 located between the emitter region 26 and the drift region 24. That is, when the voltage equal to or greater than the threshold voltage is not being applied to the trench gate electrode 32, the semiconductor device 10 is off.

When the positive voltage that is equal to or greater than the threshold voltage is being applied to the trench gate electrode 32, the body region 25 is inverted between the emitter region 26 and the drift region 24, and thus the channels are formed. Electrons are thus injected from the emitter region 26 to the drift region 24 via the channels. When the voltage equal to or greater than the threshold voltage is being applied to the trench gate electrode 32, the semiconductor device 10 is on.

When the semiconductor device 10 is on, positive holes are injected to the drift region 24 from the collector region 22 of the rear layer portion. The positive holes move through the drift region 24 in the vertical (depthwise) direction, and are emitted to the emitter electrode 28 via the body region 25.

As shown in FIG. 1, in the semiconductor device 10, the collector region 22 is formed across the entirety of the rear layer portion of the semiconductor substrate 20. As a result, when the semiconductor device 10 is on, the positive holes are injected from the entirety of the rear layer portion of the semiconductor substrate 20. The positive holes injected from the rear layer portion of the semiconductor substrate 20 into the drift region 24 of the non-channel section 10B are prevented by the carrier shielding layer 52 from moving in the vertical direction, and thus move in the horizontal direction. Since the carrier shielding layer 52 has the opening coinciding with the channel section 10A, the positive holes that have moved in the horizontal direction accumulate at the opening.

By contrast, the electrons are injected from the emitter region 26 of the channel section 10A. As a result, since the positive holes and the electrons accumulate in the channel section 10A, the conductivity modulation is activated, and the on-resistance (or on-voltage) of the semiconductor device 10 is markedly reduced.

The semiconductor device 10 is characteristic in that the non-channel section 10B and the carrier shielding layer 52 are combined. By disposing the carrier shielding layer 52 at the non-channel section 10B, the positive holes injected from the rear layer portion can be accumulated in the channel section 10A. The conductivity modulation is thereby activated in the channel section 10A, and the on-resistance (or on voltage) is reduced. In the semiconductor device 10, although the channel area is reduced by arranging the non-channel section 10B, the conductivity modulation thereby caused in the channel section 10A contributes to lowering of resistance. This compensates for the reduction in channel area, and as a result, low resistance can be obtained. As a result, the semiconductor device 10 is capable of obtaining extremely reduced on-resistance (or on-voltage).

### (First Variant)

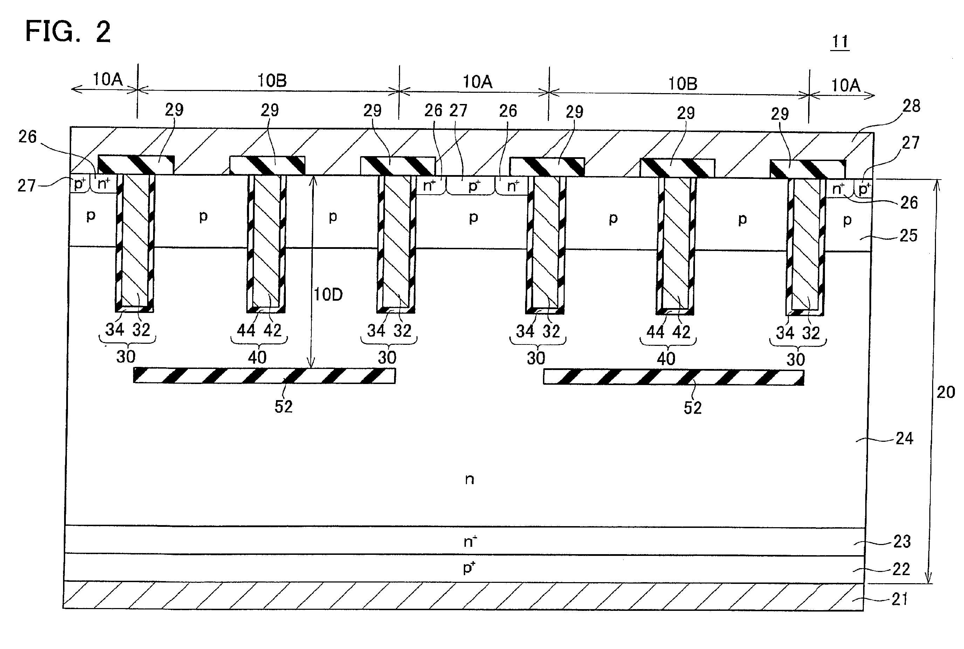

FIG. 2 schematically shows a cross-sectional view of essential parts of a semiconductor device 11. The semiconductor device 11 of FIG. 2 is a variant of the semiconductor device 10 of FIG. 1, and is characterized in comprising a dummy trench gate 40. The dummy trench gate 40 is disposed in the non-channel section 10B, and penetrates the body region 25. In this example, one dummy trench gate 40 is disposed in the non-channel section 10B. However, a greater number of dummy trench gates 40 may be formed.

The dummy trench gate 40 comprises a dummy insulating layer 44, and a dummy trench gate electrode 42 covered by the dummy insulating layer 44. Since the dummy trench gate 40 is manufactured in a common step with the trench gate 30, the dummy trench gate 40 has features in common with the trench gate 30. The dummy trench gate electrode 42 may be electrically connected to the trench gate electrode 32, or may be electrically connected to the emitter electrode 28.

As described above, in order to reduce the on-resistance (or on-voltage) in the semiconductor device 11 of the present embodiment, it is desirable to provide the non-channel section 10B that has a certain degree of area size. In such a case, in the non-channel section 10B, the distance between the trench gates 30 may be increased accordingly. In this case, a large electric field may be added to a pn junction between the drift region 24 and the body region 25 of the non-channel section 10B. Forming the dummy trench gate 40 in the non-channel section 10B can mitigate the accumulation of the electric field. The combination of the non-channel section 10B and the dummy trench gate 40 is an extremely useful technique for improving the withstand voltage of the semiconductor device 11.

### (Second Variant)

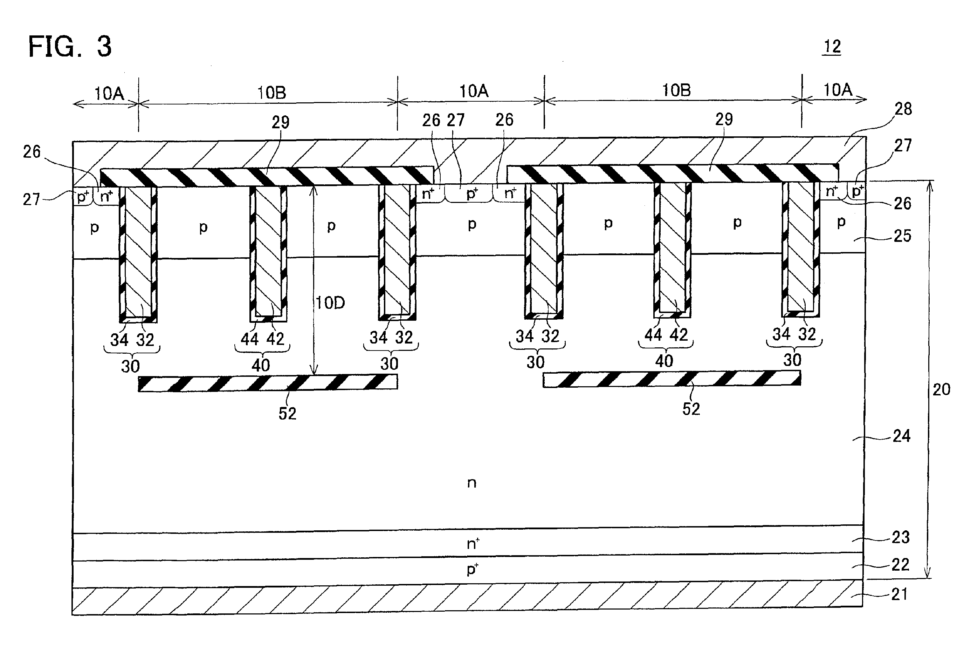

FIG. 3 schematically shows a cross-sectional view of essential parts of a semiconductor device 12. The semiconductor device 12 of FIG. 3 is a variant of the semiconductor device 11 of FIG. 2, and is **characterized in that** the body region 25 of the non-channel section 10B is covered by the interlayer insulating layer 29. As a result, the potential of the body region 25 of the non-channel section 10B is in a floating state.

When the body region 25 of the non-channel section 10B is covered by the interlayer insulating layer 29, the positive holes injected from the rear surface are not emitted to the emitter electrode 28 via the body region 25 of the non-channel section 10B. As a result, more positive holes can be accumulated in the channel section 10A. Combining the technique of covering the body region 25 of the non-channel section 10B and the technique of the carrier shielding layer 52 is extremely useful for reducing the on-resistance (or on-voltage).

### (Third Variant)

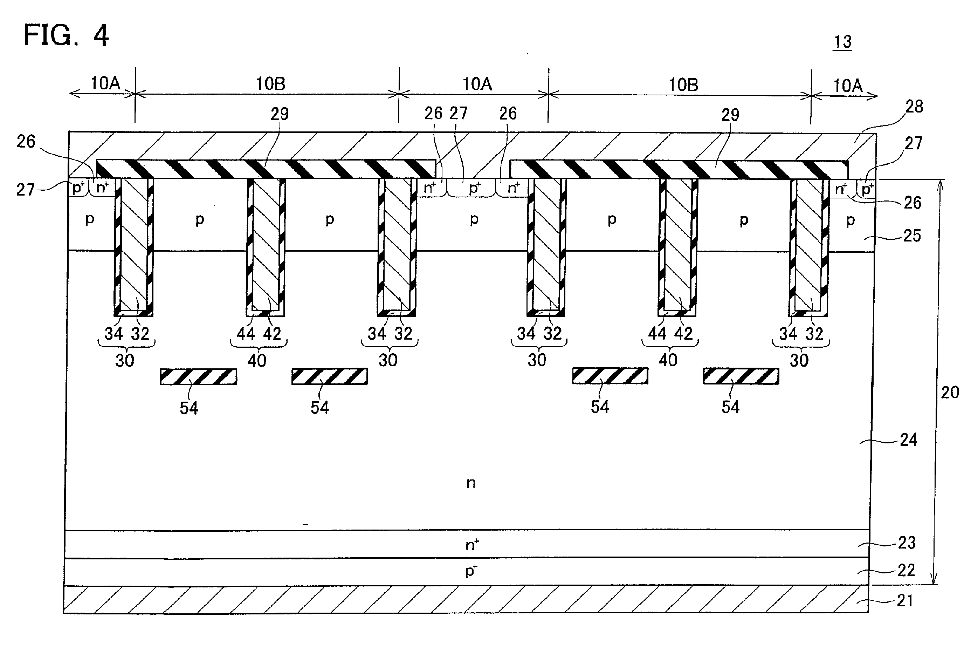

FIG. 4 schematically shows a cross-sectional view of essential parts of a semiconductor device 13. The semiconductor device 13 of FIG. 4 is a variant of the semiconductor device 11 of FIG. 2, and a carrier shielding layer 54 is divided into a plurality within the non-channel section 10B. In this example, as well, a relationship is maintained in which the occupied area ratio of the carrier shielding layer 52 in the non-channel section 10B is larger than the occupied area ratio of the carrier shielding layer 52 in the channel section 10A. In this example, a portion of the positive holes injected from the rear layer portion into the drift region 24 of the non-channel section 10B moves into the opening of the carrier shielding layer 54 disposed at the channel section 10A, and another portion of the positive holes moves into the opening of the carrier shielding layer 54 disposed at the non-channel section. Since the relationship of the occupied area ratio of the carrier shielding layer 52 is maintained in the semiconductor device 13, as well, the portion of the positive holes injected from the rear layer portion into the drift region 24 of the non-channel section 10B can be accumulated in the channel section 10A, and consequently the on-resistance (or on-voltage) is reduced.

Specific embodiments of the present teachings are described above, but these merely illustrate some possibilities of the teachings and do not restrict the scope of the claims. The art set forth in the claims includes variations and modifications of the specific examples set forth above.
Further, the technical elements disclosed in the specification or the drawings may be utilized separately or in all types of combinations, and are not limited to the combinations set forth in the claims at the time of filing of the application. Furthermore, the technology illustrated in the present specification or the drawings may simultaneously achieve a plurality of objects, and has technological utility by achieving one of those objects.

## Claims

1. A vertical semiconductor device comprising:
a semiconductor substrate including a first semiconductor region of a first conductive type, a second semiconductor region of a second conductive type disposed above the first semiconductor region, and a surface semiconductor region of the first conductive type selectively disposed above the second semiconductor region and electrically connected to a surface electrode,
a plurality of trench gates penetrating the second semiconductor region, and
a carrier shielding layer disposed in the first semiconductor region,
wherein the semiconductor substrate has a channel section and a non-channel section,
the channel section is a section located between the trench gates, and the surface semiconductor region is disposed in the channel section such that the surface semiconductor region is in contact with a side surface of at least one of the trench gates,
the non-channel section is a section located between the trench gates, and the surface semiconductor region is not disposed in the non-channel section, and
in a plan view, an occupied area ratio of the area which the carrier shielding layer located in the non-channel section occupies within the non-channel section is larger than an occupied area ratio of the area which the carrier shielding layer located in the channel section occupies within the channel section.

2. The vertical semiconductor device according to claim 1, wherein the carrier shielding layer is located in the non-channel section and opens into at least a portion of the channel section.

3. The vertical semiconductor device according to claim 1 or 2, wherein the carrier shielding layer is disposed at a depth which is deeper than the trench gate.

4. The vertical semiconductor device according to claim 3, wherein the carrier shielding layer spreads from below one of the trench gates to below another trench gate in the non-channel section.

5. The vertical semiconductor device according to any one of the claims 1-4, wherein
a dummy trench gate penetrating the second semiconductor region is disposed in the non-channel section.

6. The vertical semiconductor device according to claim 5, wherein the carrier shielding layer is disposed at a depth which is deeper than the dummy trench gate.

7. The vertical semiconductor device according to any one of claims 1-6, wherein the carrier shielding layer is disposed at a depth which is equal to or shallower than a diffusion length of carriers from a surface of the semiconductor substrate.
